Europäisches Patentamt

European Patent Office

Office européen des brevets

(11) Publication number: 0 484 902 A2

# EUROPEAN PATENT APPLICATION

(21) Application number: 91118903.3

(22) Date of filing: 06.11.91

(51) Int. Cl.⁵: **H01L 39/14**, H01L 39/24

(30) Priority: 07.11.90 JP 301935/90

(43) Date of publication of application:
**13.05.92 Bulletin 92/20**

(84) Designated Contracting States:
**CH DE FR GB IT LI**

(71) Applicant: THE FURUKAWA ELECTRIC CO.,
LTD.
6-1, 2-chome, Marunouchi Chiyoda-ku
Tokyo(JP)

(72) Inventor: Tanaka, Yasuzo, c/o The Furukawa
Electric Co., LTD
6-1, 2-chome, Marunouchi
Chiyoda-ku, Tokyo(JP)
Inventor: Yamada, Kiyoshi, c/o The Furukawa
Electric Co.,LTD
6-1, 2-chome, Marunouchi
Chiyoda-ku, Tokyo(JP)

(74) Representative: Lehn, Werner, Dipl.-Ing. et al
Hoffmann, Eitle & Partner Patentanwälte
Arabellastrasse 4
W-8000 München 81(DE)

(54) Compound superconductive wires and a method for producing the same.

(57) A compound superconductive wire has an elongate member formed of an $A_3B$ compound superconductor and an alloy member which is formed of an alloy of metal A and copper, the metal A being the constituent element of the $A_3B$ compound superconductor, and which is longitudinally mounted along with the elongate member such that the alloy member contacts with the elongate member. A method for producing a compound superconductive wire has the steps of mounting an alloy member formed of metal A and copper, the metal A being the constituent element of an $A_3B$ compound superconductor, to an elongate member formed of metal B or an alloy of mainly formed of the metal B, the metal B being the constituent element of the $A_3B$ compound superconductor, such that the alloy member longitudinally contacts with the elongate member to form a complex elongate member, performing the reduction-working to the complex elongate member to form a wire member, and heating the wire member for diffusion to make the metal B to diffuse into metal A.

This invention relates to compound superconductive wires, specifically such compound superconductive wires as exhibiting excellent superconductivity under strain when subjected to a bending, and a method for producing the same.

Various structures and methods for production have been conventionally developed in relation to compound superconductive wires of A-15 type whose structure is represented by a general formula of $A_3B$. For example, typical structures and methods for production of $Nb_3Sn$ are described as follows:

1) Bronze Method

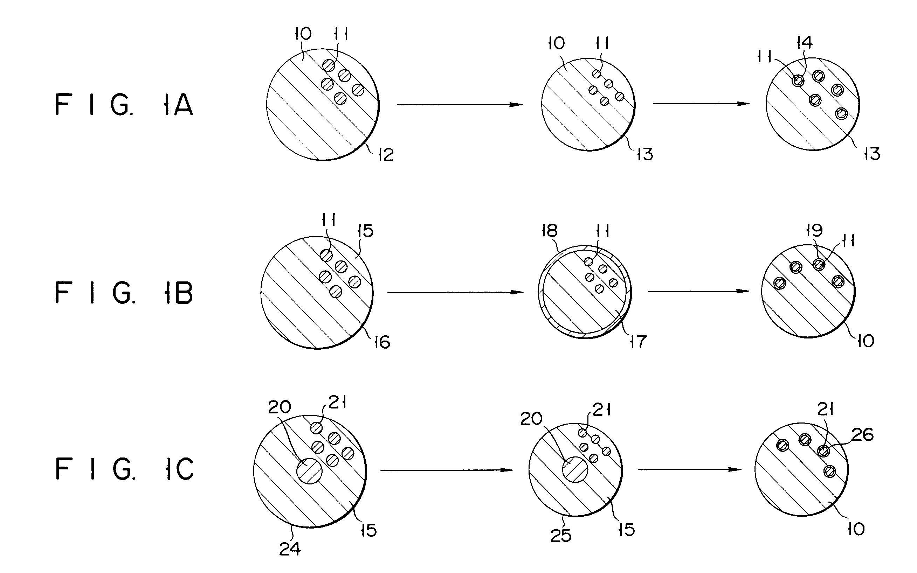

As shown in Fig. 1A, this method comprises steps of forming many holes in a Cu-Sn alloy matrix 10, inserting a Nb rod member 11 into each hole to form a complex member 12, drawing the complex member to form a wire member 13, annealing the wire member 13, and heating the wire member 13 for diffusion to obtain a $Nb_3Sn$ superconductive member 14,

2) External Diffusion Method

As shown in Fig. 1B, this method comprises steps of forming many holes in a Cu matrix 15, inserting a Nb rod member into each hole to form a complex member 16, drawing the complex member 16 to form a wire member 17, coating Sn to the wire member 17 to form a Sn layer 18, and heating the wire member 17 for diffusion to form a $Nb_3Sn$ superconductor 19,

3) Internal Diffusion Method

As shown in Fig. 1C, this method comprises steps of forming a Sn hole in the central portion and many Nb holes around the Sn hole, inserting a Sn rod member 20 into the Sn hole and a Nb rod member 21 into the Nb hole to form a complex member 24, drawing the complex member 24 to form a wire member 25, and heating the wire member 25 for diffusion to obtain a $Nb_3Sn$ superconductor 26,

4) Tube Method

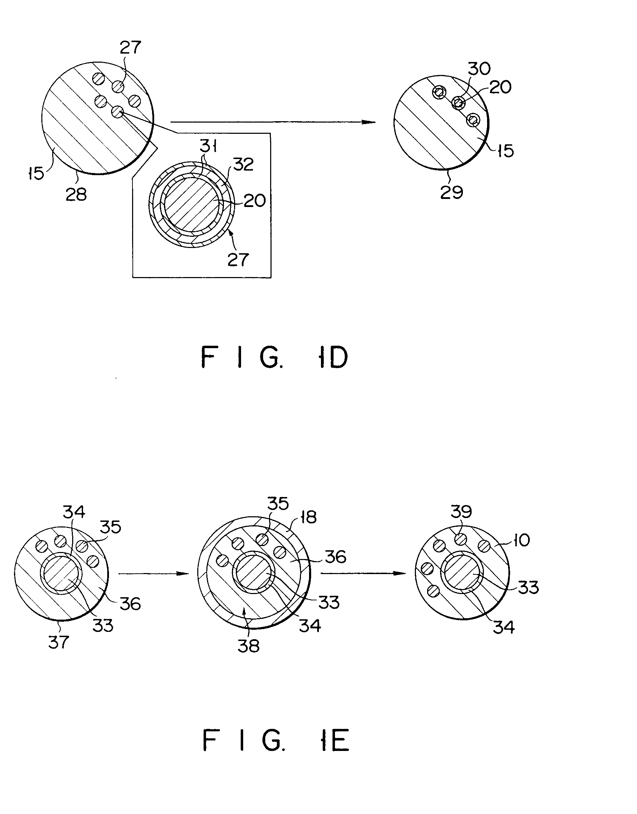

As shown in Fig. 1D, this method comprises steps of forming many holes in a Cu matrix 15, inserting a complex rod 27 into each hole to form a complex member 28, drawing the complex member 28 to form a wire member 29, and heating the wire member 29 for diffusion to obtain a $Nb_3Sn$ superconductor 30. The complex rod 27 is formed by coating the outside of the Sn rod member 20, with a Cu tubular member 31, a Nb tubular member 32, and again the Cu tubular member 31 in this order, and

5) In Situ Method

As shown in Fig. 1E, this method comprises steps of coating the outside of a Cu rod member 33 via a barrier layer 34 with a Cu tubular member 36 which has many Cu-Nb alloy rod bodies 35 embedded to form a complex member 37, drawing the complex member 37 to form a wire member 38, galvanizing the wire member 38 with Sn to form a Sn layer 18, and heating the layer 18 for diffusion to obtain a $Nb_3Sn$ superconductor 39 as well as a Cu-Sn alloy matrix 10.

However, these compound superconductive wires suffer from the following disadvantages. First, since compound superconductors formed by making Cu-Sn or Sn to react with Nb are composed of a Cu alloy obtained by annealing at high temperatures, pure metal(Nb), and fragile $Nb_3Sn$, the strength of the wires are decreased and superconductivity is also decreased by means of strain when subjected to a bending. In order to solve this problem, compound superconductive wires can be combined with Hastelloy or SUS steel to increase the strength. However, since coefficient of thermal expansion of Hastelloy or SUS steel and that of the compound superconductor are largely different, the wires are disadvantageously susceptible to strain.

Second, all of the methods other than the in situ method; the bronze method, the external diffusion method, the internal diffusion method, and the tube method comprise a step of diffusing a metal having lower melting point (Sn) into a metal having higher melting point (Nb), both of which constitute the compound superconductive wire member, and this diffusion progresses through the resulting $Nb_3Sn$ layer. Since the rate of the diffusion is slow, it takes much time to heat for diffusion.

Third, metal are left which has not been reacted after heating for diffusion, for example, metal A of higher melting point in the bronze method, the external diffusion method, and the internal diffusion method, and metal B of lower melting point in the tube method. Further, an alloy of metal B and Cu is left after

EP 0 484 902 A2

heating for diffusion in the in situ method. These residual metals or alloy exhibit little effect to reinforce the compound superconductive wire. The compound superconductive wires obtained in these conventional methods are therefore low in superconductivity under strain when subjected to a bending.

An object of this invention is to provide compound superconductive wires which can exhibit excellent superconductivity even if the strain when subjected to a bending is loaded to them.

It is also an object of this invention to provide a method for efficiently producing the compound superconductive wires stated above.

These objects can be attained by providing a compound superconductive wire having an elongate member which consists of an $A_3B$ compound superconductor, and an alloy member which consists of metal A and copper, the metal A being the constituent element of the $A_3B$ compound superconductor, the alloy member being longitudinally mounted along with said elongate member.

Further, these objects can be also attained by providing a method for producing the compound superconductive wires, having steps of longitudinally mounting an alloy member consisting of metal A, which is the constituent element of an $A_3B$ compound superconductor, and copper to an elongate member consisting of metal B, which is the constituent element of an $A_3B$ compound superconductor, or an alloy mainly containing the metal B to obtain a complex elongate member, performing the reduction-working to the complex elongate member to form a wire member, and heating the wire member for diffusion in order to make the metal B to diffuse into the metal A to produce the $A_3B$ compound superconductor.

This invention can be more fully understood from the following detailed description when taken in conjunction with the accompanying drawings, in which:

Figs. 1A-1E are cross-sectional views which show steps for producing conventional compound superconductive wires;

Fig. 2 is a cross-sectional view which shows one embodiment of a compound superconductive wire according to the invention;

Fig. 3 is a cross-sectional view which shows another embodiment of a compound superconductive wire according to the invention; and

Figs. 4A-4D are cross-sectional views which show steps for producing compound superconductor in a compound superconductor according to the invention.

According to the invention, an alloy member of an alloy consisting of metal A and copper, the metal A having the high melting point and being the constituent element of a compound superconductor of A-15 type whose general formula is $A_3B$, and the alloy member being mounted such that it contacts with a compound superconductor, has a high mechanical strength and a coefficient of thermal expansion which approximates to that of the $A_3B$ compound superconductor. The alloy member consisting of the metal A and copper mechanically reinforces the compound superconductor, resulting in an excellent superconductivity which is stable even if strain is loaded to the compound superconductive wire when subjected to a bending.

Examples of the $A_3B$ compound superconductor include $Nb_3Sn$, $V_3Ga$, and the like.

The metal A is preferably included in an amount of 25 to 95 wt.% in the alloy forming the alloy member. This is raised from the fact that if the amount of the metal A included in the alloy is less than 25 wt.%, the amount of the compound superconductor thus obtained is not sufficient, and that if an amount of the metal A included in the alloy exceeds 95 wt.%, the mechanical strength of the alloy member is lowered and an effect to reinforce the compound superconductor cannot be obtained. For example, when the metal A in the compound superconductor is Nb, an amount of Nb included is preferably 25 to 95 wt.%. When the metal A is V, 30 to 95 wt.% is preferably included in the compound superconductor.

Further, at least one metal selected from the group consisting of Ti, Zr, and Hf is preferably added to the alloy forming the alloy member within the range for forming a solid solution with copper. This addition is to promote a reinforcing effect. If the addition deviates from this range, processability of the complex member is lowered by means of undesired phase precipitation. The range of addition to make solid solution with copper is 0.5 to 4 wt.% for Ti, 0.03 to 0.15 wt.% for Zr, and 0.01 to 0.1 wt.% for Hf.

A diffusion barrier layer may be formed outside of the alloy member formed of the alloy of the metal A and copper to avoid diffusion of the metal A. Examples of metals used for the diffusion barrier layer include Ta when the compound superconductor is $Nb_3Sn$, and Nb, Ta, and the like when the compound superconductor is $V_3Ga$.

Copper used with the metal A to form the alloy member advantageously improve the diffusion of the metal B into the metal A. Moreover, the alloy member consisting of the metal A and copper has the coefficient of thermal expansion which approximates to that of the compound superconductor, and the alloy member can sufficiently reinforce the compound superconductor. Copper used in the most outside layer is to improve processability during drawing and the like.

3

Compound superconductive wires according to the invention are produced by mounting an alloy member formed of an alloy of the metal A, which is the constituent element of $A_3B$ compound superconductor, and copper, and another alloy member formed of metal B, which is the constituent element of the compound superconductor, only or an alloy of the metal B and copper, such that both alloys are contacted with each other, heating the alloys for diffusion, and making the metal B to diffuse into the metal A. Here, an excessive amount of the alloy member formed of the alloy of metal A and copper is used in relation to the metal B so that the alloy member may be left in the compound superconductive wire after heating for diffusion. Specifically, after the metal A is consumed to diffuse into the metal B during heating for diffusion, the residue of the alloy member formed of the alloy of the metal A and copper is preferably left to the extent that the alloy member formed of the alloy of the metal A and copper can sufficiently reinforce the compound superconductor. An amount of the alloy member formed of the alloy of the metal A and copper is accordingly adjusted. For example, if an amount of Sn of the metal B is 0.2 weight part or less in relation to one weight part of an alloy member formed of an alloy of Cu-60 wt.% Nb, the Cu-Nb alloy member can be left after $Nb_3Sn$ superconductor is formed.

Heating conditions for diffusion vary depending on kinds of compound superconductors used. For example, when the compound superconductor is $Nb_3Sn$, temperatures and time for heating are preferably 500 to 700°C and 30 to 450 hours. When $V_3Ga$ is used, heating at 450 to 680°C for 25 to 400 hours is preferable.

Working of the reduction of area (the reduction-working) is made by commonly used processes such as wire drawing and rolling.

According to the invention, copper dispersed in an alloy member of metal A and copper enables the metal B to sufficiently diffuse into the metal A. Diffusion of the metal B through $A_3B$ layer formed into the metal A can be avoided, which is required for the conventional methods. Compound superconductor can thus be efficiently produced in a short heating time.

Embodiments according to the invention is described in detail with reference to drawings appended as follows.

Example 1

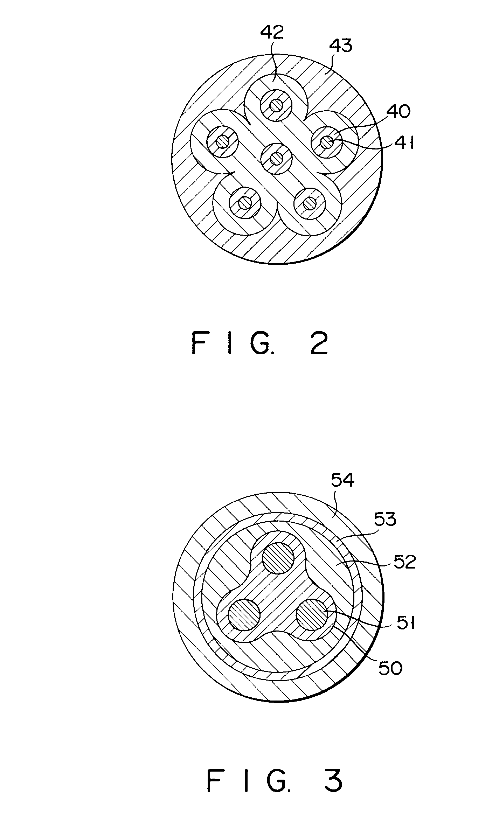

Fig. 2 shows a cross-sectional view of one embodiment of a compound superconductive wire according to the invention. A reference number 40 indicates a $V_3Ga$ superconductor. A reference number 41 indicates Ga-2 wt.% Cu alloy inside of the $V_3Ga$ superconductor 40. Outside of the $V_3Ga$ superconductor 40 is mounted a Cu-45 wt.%V alloy 42. Outside of the Cu-45 wt.%V alloy 42, a stabilizing metal 43 is further mounted which is formed of copper.

A method of this compound superconductive wire is as follows; a Cu-45 wt.%V alloy is melted in an arc melting furnace, and solidified by cooling in a copper casting mold to obtain an ingot. This ingot was subjected to rolling and lathe working to form a rod member of 10 mmø-outside diameter. Next, a hole of 4.1 mmø-inside diameter was longitudinally formed in the central portion of this rod member. Into this hole, a rod member formed of Ga-2 wt.% Cu alloy having 4 mmø-outside diameter was inserted to form a complex rod member. The six complex rod members thus obtained were inserted into a Cu pipe having a 35 mmø-outside diameter and 27 mmø-inside diameter, and sealed by capsulating either end of the Cu pipe. The obtained Cu pipe was subjected to the working of the reduction of area to form a wire member of 0.3 mmø-outside diameter. This wire member was heated at 600°C for 92 hours for diffusion to form an objective $V_3Ga$ superconductor. Thus, a superconductive wire of one embodiment of the invention was obtained.

On the other hand, a comparative superconductive wire of 0.3 mmø-outside diameter was formed according to the same method as stated with the exception that metal V was used in place of the Cu-45 wt.%V alloy.

The critical currents of these compound superconductive wires were measured in a 10T magnetic field. The result was shown in Table 1 as follows.

4

## Table 1

| critical current (A) | | strain (%) | | | |
|---|---|---|---|---|---|
| | | 0 | 0.6 | 1.5 | 2 |
| | embodiment | 20 | 21 | 18 | 10 |
| | comparative embodiment | 18 | 10 | 3 | 0 |

As apparent from the Table 1, both compound superconductive wires according to the embodiment and the comparative embodiment showed the same critical current under no strain and no bending. However, when strains are loaded to the wires, the critical currents of the wires were different; the compound superconductive wire according to the embodiment altered little in the critical current under a ca. 1.5% loaded bending, while the comparative wire decreased in the critical current to ca. 60% under a ca. 0.6% deformation in comparison with that under no strain. This fact reveals that the Cu-45 wt.%V alloy member shows an effect to reinforce a compound superconductor.

Example 2

Fig. 3 is a cross-sectional view of a compound superconductive wire according to another embodiment of the invention. The reference number 50 indicates a $Nb_3Sn$ superconductor. The reference number 51 indicates each of three Sn-4 wt.% Cu alloy in the $Nb_3Sn$ superconductor 50. Outside of the $Nb_3Sn$ superconductor 50, a Cu-Nb alloy 52 is mounted. Outside of the Cu-Nb alloy 52, a diffusion barrier layer 53 consisted of Ta is mounted. Further, outside of the diffusion barrier layer 53, a stabilizing metal 54 consisted of Cu is mounted.

This compound superconductive wire was produced as follows; a Cu-Nb (25-90 wt.%) alloy was melted in an arc melting furnace, and solidified by cooling in a copper casting mold to obtain an ingot. This ingot was subjected to rolling and lathe working to form a rod member of 27 mmØ-outside diameter. Next, three holes of 6.1 mmØ-inside diameter were formed in this rod member. Into each hole, a rod member of 6 mmØ-outside diameter formed of Sn-4 wt.%Cu alloy was inserted to form a complex rod member. This complex rod member was coated with a tantalum pipe of 28.9 mmØ-outside diameter and of 27.1 mmØ-inside diameter, and with a Cu pipe of 35 mmØ-outside diameter and 29 mmØ-inside diameter in this order, and sealed by capsulating either end of the Cu pipe. This Cu pipe was subjected to the working of the reduction of area by means of hydrostatic extrusion and subjected to drawing to form a wire member of 0.3 mmØ. The obtained wire member was heated under a condition of 570°C × 150 hr. or a 570°C × 300 hr. for diffusion to form a $Nb_3Sn$ superconductor. This is an objective compound superconductive wire according to the embodiment.

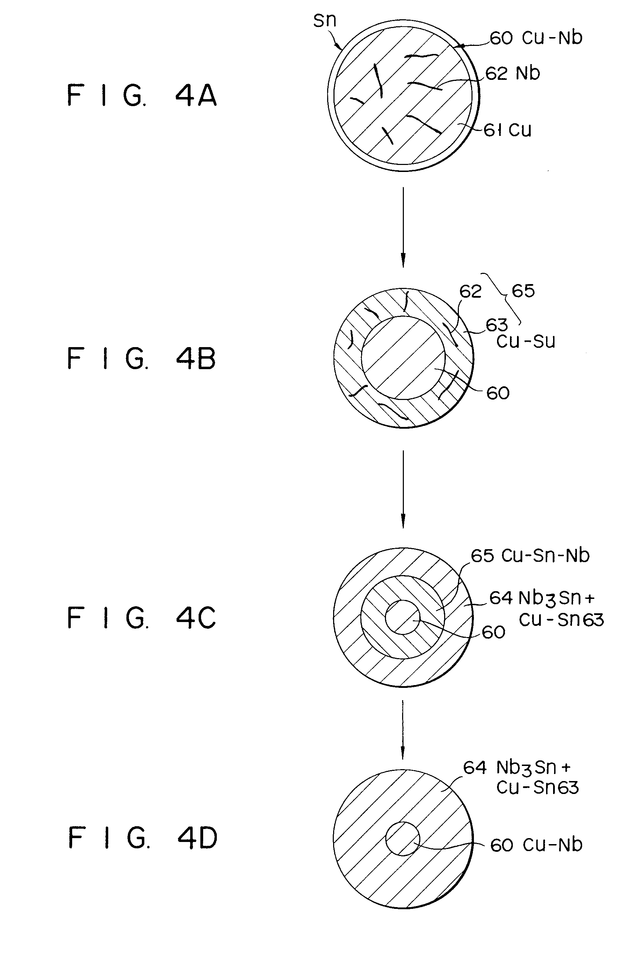

Steps for producing the $Nb_3Sn$ superconductor are shown in Figs. 4A-4C. As shown in Fig. 4A, a Cu-Nb alloy 60 is formed of Cu 61 and Nb 62 which is mounted in the Cu 61 in dendrite fashion. When Sn is diffused into the Cu-Nb alloy 60, a Cu-Sn alloy 63 is formed which contain the Nb 62 in dendrite fashion outside of the Cu-Nb alloy 60 in dendrite fashion as shown in Fig. 4B, since Sn is likely to react with the Cu 61 rather than with the Nb 62. After that, as shown in Fig. 4C, Sn in the Cu-Sn alloy 63 react with Nb to form a $Nb_3Sn$ superconductor 64 and Cu-Sn-Nb alloy phase 65 left outside of the Cu-Nb alloy 60. And finally, as shown in Fig. 4D, Cu-Nb alloy 60 left inside of the $Nb_3Sn$ superconductor 64.

Separately, a comparative compound superconductive wire was produced by forming a wire member of a 0.3 mmØ-outside diameter according to the same method as that for said embodiment, with the exception that metal Nb and a Cu-Nb (15 and 97 wt.%) alloy were used in place of the Cu-Nb alloy.

The critical currents of these compound superconductive wires were measured under a 10T magnetic field (unit:A). The result was shown in Table 2 as follows.

Table 2

| Nb wt.% in Cu-Nb alloy | | heating time (hour) | | | | rupture strength at room temperature (kg/mm$^2$) |
|---|---|---|---|---|---|---|
| | | 300 | 150 | | | |
| | | strain (%) | | | | |
| | | 0 | 0 | 0.6 | 1.5 | |
| embodment | 25 | 18 | 18 | 19 | 18 | 25 |
| | 50 | 18 | 19 | 21 | 20 | 35 |
| | 75 | 19 | 20 | 22 | 20 | 30 |
| | 90 | 20 | 19 | 18 | 15 | 20 |
| comparative example | Nb | 18 | 10 | 3 | 0 | 12 |
| | 15 | 15 | 13 | 14 | 13 | 15 |
| | 97 | 19 | 11 | 5 | 1 | 15 |

As apparent from the Table 2, when heating for 300 hours and no strain was applied and no strain was loaded, both of compound superconductive wires according to the embodiments and comparative examples showed the same critical current. However, when heating time was decreased to 150 hours, the critical current of the comparative example was accordingly decreased by half. The critical current was further decreased under a loaded strain. On the other hand, the critical currents of compound superconductive wires according to the embodiments remained almost the same value even under a reduced heating time and a ca. 1% loaded strain. This is because the diffusion rates of Nb into Sn for the embodiments are higher than those for the comparative embodiments, due to diffusion promoting activity of Cu in the Cu-Nb alloy.

The critical current of a compound superconductive wire varies depending on an amount of Nb in a Cu-Nb alloy, for example, it is decreased if the amount of Nb included exceeds 95 wt.% or is less than 25 wt.%. Especially, if the amount of Nb included exceeds 95 wt.%, superconductivity of the wire is likely to be affected by means of strain. This fact reveals that an effect of a Cu-Nb alloy to reinforce a compound superconductor is higher than that of metal Nb. For reference, the rupture strengths of the compound superconductive wires according to the embodiments and comparative embodiments were measured at room temperature. The result was that the rupture strength of the embodiment approximated to that of the comparative examples utilizing metal Nb, if an amount of Nb included in the Cu-Nb alloy exceeded 95 wt.%. Overall, it was concluded that the compound superconductive wires according to the embodiments can be produced by heating for a shorter period of time than that for the comparative embodiments, and superconductivity of the embodiments is also resistant against strain.

Example 3

Compound superconductive wires were produced according to the same method as that for the Example 2 with the exception that the Cu-Nb alloy was replaced with a Cu-50 wt.% Nb alloy, a Cu-50 wt.% Nb-2 wt.% Ti alloy, and a Cu-50 wt.% Nb-0.1 wt.% Zralloy.

The critical currents of these compound superconductive wires were measured under a 10T magnetic field. The result was shown in Table 3 as follows.

Table 3

| heating time (hour) strain (%) | 300 | 150 | | | | rupture strength at room temperature (kg/mm$^2$) |
|---|---|---|---|---|---|---|
| | 0 | 0 | 0.6 | 1.5 | 3 | |
| Cu-50wt.%Nb | 18 | 19 | 21 | 20 | 10 | 35 |
| Cu-50wt.%Nb -2wt.%Ti | 20 | 22 | 25 | 28 | 20 | 40 |
| Cu-50wt.%Nb -0.1wt%Zr | 21 | 20 | 23 | 25 | 21 | 38 |

As shown in the Table 3, the strain-resistance was further increased by adding Ti and Zr into the Cu-Nb alloy.

As described above, according to this invention, a compound superconductive wire can be produced whose superconductivity is not affected by means of strain when subjected to a bending, because an alloy member formed of an alloy of metal A and copper is mounted such that the alloy member contacts with an A$_3$B compound superconductor.

Further, diffusion time required for producing a compound superconductor can be reduced according to the invention.

According to the invention, either of a multi-core structure shown in Fig. 1 or a single-core structure shown in Fig. 2 can be produced by controlling the diffusion reaction. The multi-core structure can be applied for pulse and alternative current use, and the single-core structure to direct current use.

Also, since a compound superconductive wire according to the invention shows an excellent strain-resistance, a wider range of application can be expected including use under higher magnetic field than that for conventional use.

**Claims**

1. A compound superconductive wire comprising an elongate member formed of an A$_3$B compound superconductor and an alloy member which is formed of an alloy of metal A and copper, the metal A being the constituent element of the A$_3$B compound superconductor, and which is longitudinally mounted along with said elongate member such that the alloy member contacts with the elongate member.

2. The compound superconductive wire according to the claim 1, characterized in that said elongate member is a tubular member or a wire member.

3. The compound superconductive wire according to the claim 1, characterized in that said alloy member formed of metal A and copper is mounted outside of the elongate member.

4. The compound superconductive wire according to the claim 1, characterized in that the alloy member formed of metal A and copper is mounted inside of the elongate member.

5. The compound superconductive wire according to the claim 1, characterized in that an amount of metal A included in the alloy member formed of metal A and copper is 25 wt.% to 95 wt.%.

6. The compound superconductive wire according to the claim 1, characterized in that at least one metal selected from a group consisting of Ti, Zr, and Hf is included in the alloy forming the alloy member formed of metal A and copper, within a range that the metal can form a solid solution with copper.

7. The compound superconductive wire according to the claim 1, characterized in that the metal A is Nb or V.

8. The compound superconductive wire according to the claim 1, characterized in that the A$_3$B compound superconductor is Nb$_3$Sn or V$_3$Ga.

9. The compound superconductive wire according to the claim 1, characterized in that a diffusion barrier layer is further mounted outside of said alloy member.

10. The compound superconductive wire according to the claim 1, characterized in that a stabilizing layer formed of copper is mounted as the most outside layer.

11. A method for producing a compound superconductive wire comprising the steps of mounting an alloy member formed of metal A and copper, the metal A being the constituent element of an $A_3B$ compound superconductor, to an elongate member formed of metal B or an alloy of mainly formed of the metal B, the metal B being the constituent element of the $A_3B$ compound superconductor, such that the alloy member longitudinally contacts with said elongate member to form a complex elongate member, performing the reduction-working to said complex elongate member to form a wire member, and heating said wire member for diffusion to make the metal B to diffuse into metal A.

12. The method according to the claim 11, characterized in that an alloy member formed of an alloy of metal A and copper is mounted outside of said elongate member.

13. The method according to the claim 11, characterized in that the alloy member of metal A-copper is mounted in an excessive amount in relation to that of metal B.

14. The method according to the claim 11, characterized in that a step of forming a diffusion barrier layer outside of said complex elongate member is further provided.

15. The method according to the claim 11, characterized in that a step for forming a stabilizing layer formed of copper outside of said complex elongate member is further provided.

F I G. 1A

F I G. 1B

F I G. 1C

EP 0 484 902 A2

F I G. 1D

F I G. 1E

F I G. 2

F I G. 3

F I G. 4A

Sn
60 Cu‑Nb
62 Nb
61 Cu

F I G. 4B

62 ⎫ 65
63 ⎭
Cu‑Su
60

F I G. 4C

65 Cu‑Sn‑Nb
64 Nb$_3$Sn +
Cu‑Sn63
60

F I G. 4D

64 Nb$_3$Sn +
Cu‑Sn63
60 Cu‑Nb